# EUROPEAN PATENT APPLICATION

(11) **EP 4 105 997 A1**
(43) Date of publication of application: **21.12.2022**
(21) Application number: 20918708.7
(22) Date of filing: 13.02.2020
(51) Int. Cl.: H01L 27/15, H01L 27/12, H01L 33/36, H01L 33/00

(54) **SUBSTRATE FOR MANUFACTURING DISPLAY DEVICE AND MANUFACTURING METHOD THEREFOR**

(30) Priority: 10.02.2020 KR 20200015793
(71) Applicant: LG Electronics, Inc., Yeongdeungpo-gu Seoul 07336 (KR)
(72) Inventor: HEO, Younho, Seoul 06772 (KR); LEE, Jinhyung, Seoul 06772 (KR); MOON, Seongmin, Seoul 06772 (KR); PARK, Changseo, Seoul 06772 (KR)
(74) Representative: Vossius & Partner Patentanwälte Rechtsanwälte mbB
(86) International application number: PCT/KR2020/002036
(87) International publication number: WO 2021/162147

(57) **Abstract**

A substrate for manufacturing a display device according to the present invention includes a base part; assembly electrodes extending in one direction and disposed on the base part at predetermined intervals; an etch stop layer formed on at least a portion of the base part; a barrier wall part formed on the etch stop layer while forming a cell on which a semiconductor light emitting device is mounted along an extension direction of the assembly electrodes. The etch stop layer is formed on at least a first region in which the assembly electrodes are formed among the entire region of the base part.

## Description

### [Technical Field]

The present invention relates to a substrate for manufacturing a display device used in manufacturing a display device using a semiconductor light emitting device having a size of several to several tens of µm, and a method for manufacturing the same.

### [Background Art]

Recently, liquid crystal displays (LCD), organic light emitting device (OLED) displays, and micro LED displays are competing to implement large-area displays in the display technology field.

On the other hand, when a semiconductor light emitting device (micro LED) having a diameter or cross-sectional area of 100 µm or less is used for a display, very high efficiency can be provided because the display does not absorb light using a polarizer or the like. However, since a large display requires millions of semiconductor light emitting devices, it is difficult to transfer the devices compared to other technologies.

Technologies that are currently being developed as a transfer process include pick & place, Laser Lift-off (LLO), or self-assembly. Among them, the self-assembly method is a method in which the semiconductor light emitting device finds its own position in a fluid, and is the most advantageous method for realizing a large screen display device.

On the other hand, the self-assembly method includes a method of directly assembling the semiconductor light emitting device to the final substrate (or wiring substrate) on which wiring is formed, and a method of assembling the semiconductor light emitting device on the assembly substrate and transferring the semiconductor light emitting device to the final substrate through an additional transfer process. The method of direct assembly to the final substrate is efficient in terms of process, and when using the assembly substrate, there is an advantage in that structures for self-assembly can be added without limitation, so the two methods are selectively used.

### [Disclosure]

### [Technical Problem]

An object of the present invention is to provide a substrate for manufacturing a display device used in manufacturing a display device using a semiconductor light emitting device having a size of several to several tens of µm.

In particular, an object of the present invention is to provide a substrate for manufacturing a display device having a structure capable of lowering the defect occurrence rate of the substrate and improving the transfer speed and yield of a semiconductor light emitting device.

### [Technical Solution]

The substrate for manufacturing a display device according to the present invention includes base part; assembly electrodes extending in one direction and disposed on the base part at predetermined intervals; an etch stop layer formed on at least a portion of the base part; and a barrier wall part formed on the etch stop layer while forming a cell on which a semiconductor light emitting device is mounted along an extension direction of the assembly electrodes. The etch stop layer can be formed on at least a first region in which the assembly electrodes are formed among the entire region of the base part.

According to the present invention, the etch stop layer can be further formed on a second region of the entire region of the base part in which the assembly electrodes are not formed.

According to the present invention, the etch stop layer can be an oxide layer including at least one of In, Sn, and Zn.

According to the present invention, it can comprise a first insulating layer formed on a second region of the entire region of the base part in which the assembly electrodes are not formed.

According to the present invention, it can comprise a second insulating layer formed along the inner surface of the cell and one surface of the barrier wall part.

The method of manufacturing a substrate for manufacturing a display device according to the present invention includes a step of forming assembly electrode patterns extending in one direction on the base part at predetermined intervals; a step of forming an etch stop layer on at least a first region in which the assembly electrodes are formed among the entire region of the base part; a step of forming a barrier wall part on a second region in which the assembly electrodes are not formed among the entire region of the first region and the base part; a step of forming a cell in which a semiconductor light emitting device is seated by etching the barrier wall part to a predetermined depth.

According to the present invention, it is characterized in that the etch stop layer is further formed on the second region in which the assembly electrodes are not formed among the entire region of the base part.

According to the present invention, the step of forming the cell is characterized in that the barrier wall part is etched to expose the etch stop layer.

According to the present invention, the etch stop layer is characterized in that it is an oxide layer including at least one of In, Sn, and Zn.

According to the present invention, it characterized in that it further comprises the step of forming a second insulating layer along the inner surface of the cell and one surface of the barrier wall part.

### [Effects of the Invention]

The substrate for manufacturing a display device according to the present invention has an effect of forming an etch stop layer on at least the front surfaces of the assembly electrodes to uniformly form cells during the substrate manufacturing process. Specifically, since etching is performed until the etch stop layer formed on the assembly electrodes is exposed during cell formation, there is an effect that can prevent defects (defect due to over-etching) in which the assembly electrodes disposed under the etch stop layer are etched.

Also, the substrate for manufacturing a display device according to the present invention has an effect of improving the transfer speed and transfer yield of the semiconductor light emitting device through self-assembly.

### [Description of Drawings]

FIG. 1 is a conceptual diagram illustrating an embodiment of a display device using a semiconductor light emitting device of the present invention.
FIG. 2 is a partially enlarged view of a portion A of the display device of FIG. 1.
FIG. 3 is an enlarged view of the semiconductor light emitting device of FIG. 2.
FIG. 4 is an enlarged view showing another embodiment of the semiconductor light emitting device of FIG. 2.
FIGS. 5A to 5E are conceptual views for explaining a new process of manufacturing the above-described semiconductor light emitting device.
FIG. 6 is a conceptual diagram showing an example of a self-assembly apparatus of a semiconductor light emitting device according to the present invention.
FIG. 7 is a block diagram of the self-assembly apparatus of FIG. 6.
FIGS. 8A to 8E are conceptual views illustrating a process of self-assembling a semiconductor light emitting device using the self-assembly apparatus of FIG. 6.
FIG. 9 is a conceptual diagram for explaining the semiconductor light emitting device of FIGS. 8A to 8E.
FIGS. 10A to 10C are conceptual views illustrating a state in which a semiconductor light emitting device is transferred after a self-assembly process according to the present invention.
FISG. 11 to 13 are flowcharts illustrating a method of manufacturing a display device including a semiconductor light emitting device that emits red (R), green (G), and blue (B) light.
FIGS. 14(a) to 14(c) are conceptual views showing a cell internal cross-section of a substrate of related art for manufacturing a display device.
FIG. 15A is a view showing a top surface of a substrate for manufacturing a display device according to a first embodiment of the present invention, and FIGS. 15B and 15C are cross-sectional views taken along line AA' of FIG. 15A.
FIG. 16A is a view showing a top surface of a substrate for manufacturing a display device according to a second embodiment of the present invention, and FIG. 16B is a cross-sectional view of the cell inside taken along line BB' of FIG. 16A.
FIGS. 17A to 17F are conceptual views for explaining a method of manufacturing a substrate for manufacturing a display device according to the first embodiment of the present invention.
FIGS. 18A to 18F are conceptual views for explaining a method of manufacturing a substrate for manufacturing a display device according to a second embodiment of the present invention.

### [Mode for Invention]

Hereinafter, the embodiments disclosed in the present specification will be described in detail with reference to the attached drawings, but the same or similar components are given the same reference sign regardless of the reference numerals, and the redundant description thereof will be omitted. The suffixes "module" and "part" for components used in the following description are given or mixed in consideration of only the ease of writing the specification, and do not have a meaning or role distinct from each other by themselves. Also, in describing the embodiments disclosed in the present specification, if it is determined that detailed descriptions of related known technologies can obscure the gist of the embodiments disclosed in the present specification, the detailed description thereof will be omitted. Also, the attached drawings are only for easy understanding of the embodiments disclosed in the present specification, and should not be construed as limiting the technical idea disclosed herein by the attached drawings. Also, when an element such as a layer, region or substrate is referred to as being "on" another component, it will be understood that this can be directly on other elements or intervening elements can exist in between.

A display device described in this specification can include a mobile phone, a smart phone, a laptop computer, a digital broadcasting terminal, a PDA (personal digital assistant), a PMP (portable multimedia player), a navigation, a slate PC, a tablet PC (tablet PC), an ultra-book, a digital TV, a desktop computer, etc. However, the configuration according to the embodiment described in this specification can be applied as long as it can include a display even in a new product form to be developed later.

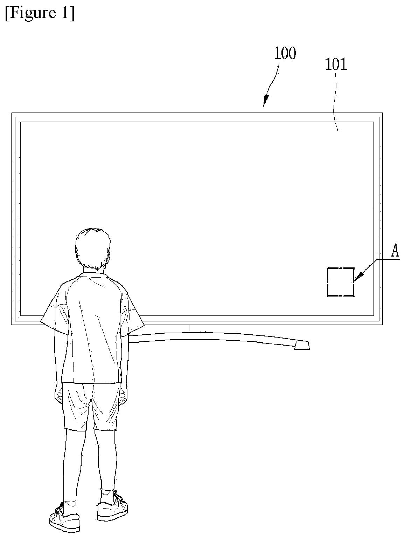

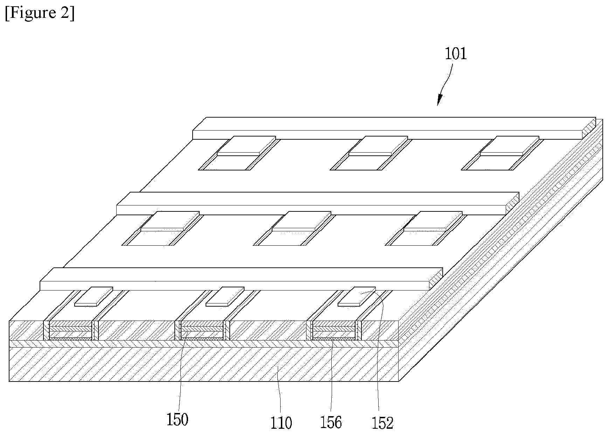

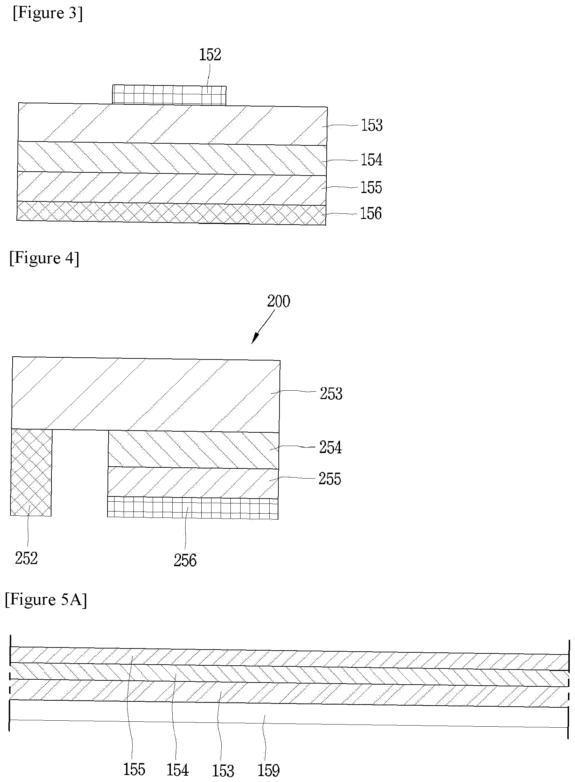

FIG. 1 is a conceptual diagram showing an embodiment of a display device using a semiconductor light emitting device of the present invention, FIG. 2 is a partial enlarged view of part A of the display device of FIG. 1, FIG. 3 is an enlarged view of the semiconductor light emitting device of FIG. 2, FIG. 4 is an enlarged view illustrating another embodiment of the semiconductor light emitting device of FIG. 2.

As illustrated, information processed by the control unit of the display device 100 can be output from the display module 140. A closed-loop case 101 surrounding an edge of the display module can form a bezel of the display device.

The display module 140 can include a panel 141 on which an image is displayed, the panel 141 can include a micro-sized semiconductor light emitting device 150 and a wiring substrate 110 on which the semiconductor light emitting device 150 is mounted.

A wiring can be formed on the wiring substrate 110 to be connected to the n-type electrode 152 and the p-type electrode 156 of the semiconductor light emitting device 150. Through this, the semiconductor light emitting device 150 can be provided on the wiring substrate 110 as an individual pixel that emits light.

The image displayed on the panel 141 is visual information, and is implemented by independently controlling the light emission of sub-pixels arranged in a matrix form through the wiring.

In the present invention, a micro LED (Light Emitting Diode) is exemplified as a type of the semiconductor light emitting device 150 that converts current into light. The micro LED can be a light emitting diode formed in a small size of 100 micrometers or less. In the semiconductor light emitting device 150, blue, red, and green colors are respectively provided in the light emitting region, and a unit pixel can be implemented by a combination thereof. That is, the unit pixel means a minimum unit for implementing one color, and at least three micro LEDs can be provided in the unit pixel.

More specifically, referring to FIG. 3, the semiconductor light emitting device 150 can have a vertical structure.

For example, the semiconductor light-emitting device 150 can be implemented as a high-output light-emitting device that emits various types of light, including blue, by mainly using gallium nitride (GaN) and adding indium (In) and/or aluminum (Al) together.

Such a vertical semiconductor light emitting device includes a p-type electrode 156, a p-type semiconductor layer 155 formed on the p-type electrode 156, an active layer 154 formed on the p-type semiconductor layer 155, an n-type semiconductor layer 153 formed on the active layer 154, and an n-type electrode 152 formed on the n-type semiconductor layer 153. In this case, the lower p-type electrode 156 can be electrically connected to the p-electrode of the wiring substrate, and the upper n-type electrode 152 can be electrically connected to the n-electrode at the upper side of the semiconductor light emitting device. The vertical semiconductor light emitting device 150 has a great advantage in that it is possible to reduce the chip size because electrodes can be arranged up and down.

As another example, referring to FIG. 4, the semiconductor light emitting device can be a flip chip type light emitting device.

As an example, the semiconductor light emitting device 250 includes a p-type electrode 256, a p-type semiconductor layer 255 on which the p-type electrode 256 is formed, an active layer 254 formed on the p-type semiconductor layer 255, an n-type semiconductor layer 253 formed on the active layer 254, and an n-type electrode 252 spaced apart from the p-type electrode 256 in the horizontal direction on the n-type semiconductor layer 253. In this case, both the p-type electrode 256 and the n-type electrode 152 can be electrically connected to the p-electrode and the n-electrode of the wiring substrate under the semiconductor light emitting device.

The vertical semiconductor light emitting device and the horizontal semiconductor light emitting device can be a green semiconductor light emitting device, a blue semiconductor light emitting device, or a red semiconductor light emitting device, respectively. In the case of a green semiconductor light emitting device and a blue semiconductor light emitting device, gallium nitride (GaN) is mainly used, and indium (In) and/or aluminum (Al) are added together, so that it can be implemented as a high-output light emitting device emitting green or blue light. For this example, the semiconductor light emitting device can be a gallium nitride thin film formed in various layers such as n-Gan, p-Gan, AlGaN, InGan, etc. Specifically, the p-type semiconductor layer can be P-type GaN, and the n-type semiconductor layer can be N-type GaN. However, in the case of a red semiconductor light emitting device, the p-type semiconductor layer can be P-type GaAs, and the n-type semiconductor layer can be N-type GaAs.

Also, the p-type semiconductor layer can be P-type GaN doped with Mg on the p-electrode side, and the n-type semiconductor layer can be N-type GaN doped with Si on the n-electrode side. In this case, the above-described semiconductor light emitting devices can be semiconductor light emitting devices without an active layer.

On the other hand, referring to FIGS. 1 to 4, since the light emitting diode is very small, in the display panel, self-luminous unit pixels can be arranged in a high definition, through this, a high-definition display device can be implemented.

In the display device using the semiconductor light emitting device of the present invention described above, the semiconductor light emitting device grown on a wafer and formed through mesa and isolation is used as an individual pixel. In this case, the micro-sized semiconductor light emitting device 150 should be transferred to a pre-set position on the substrate of the display panel on the wafer. There is a pick and place method as such a transfer technology, but the success rate is low and a lot of time is required. As another example, there is a technique of transferring several devices at once using a stamp or a roll, but there is a limit to the yield, which is not suitable for a large screen display. The present invention proposes a new manufacturing method and manufacturing device of a display device that can solve these problems.

To this end, hereinafter, a new method of manufacturing a display device will be described. FIGS. 5A to 5E are conceptual views for explaining a new process of manufacturing the above-described semiconductor light emitting device.

In this specification, a display device using a passive matrix (PM) type semiconductor light emitting device is exemplified. However, the examples described below are also applicable to an active matrix (AM) type semiconductor light emitting device. Also, although a method of self-assembly a horizontal semiconductor light emitting device is exemplified, it is also applicable to a method of self-assembly a vertical semiconductor light emitting device.

First, according to the manufacturing method, the first conductivity type semiconductor layer 153, the active layer 154, and the second conductivity type semiconductor layer 155 are grown on the growth substrate 159, respectively (refer to FIG. 5A).

When the first conductivity type semiconductor layer 153 is grown, next, an active layer 154 is grown on the first conductivity type semiconductor layer 153, next, a second conductivity type semiconductor layer 155 is grown on the active layer 154. In this way, when the first conductivity type semiconductor layer 153, the active layer 154, and the second conductivity type semiconductor layer 155 are sequentially grown, as shown in FIG. 5A, the first conductivity type semiconductor layer 153, the active layer 154, and the second conductivity type semiconductor layer 155 form a stacked structure.

In this case, the first conductivity type semiconductor layer 153 can be a p-type semiconductor layer, and the second conductivity type semiconductor layer 155 can be an n-type semiconductor layer. However, the present invention is not necessarily limited thereto, and examples in which the first conductivity type is n-type and the second conductivity type is p-type are also possible.

Also, although the case in which the active layer is present is exemplified in this embodiment, a structure without the active layer is possible in some cases as described above. For this example, the p-type semiconductor layer can be P-type GaN doped with Mg, and the n-type semiconductor layer can be N-type GaN doped with Si on the n-electrode side.

The growth substrate 159 (wafer) can be formed of a material having a light-transmitting property, for example, any one of sapphire (Al2O3), GaN, ZnO, and AlO, but is not limited thereto. Also, the growth substrate 1059 can be formed of a material suitable for semiconductor material growth, a carrier wafer. Also, it can be formed of a material with excellent thermal conductivity, including a conductive substrate or an insulating substrate, for example, at least one of Si, GaAs, GaP, InP, Ga2O3 or a SiC substrate having higher thermal conductivity than a sapphire (Al2O3) substrate can be used.

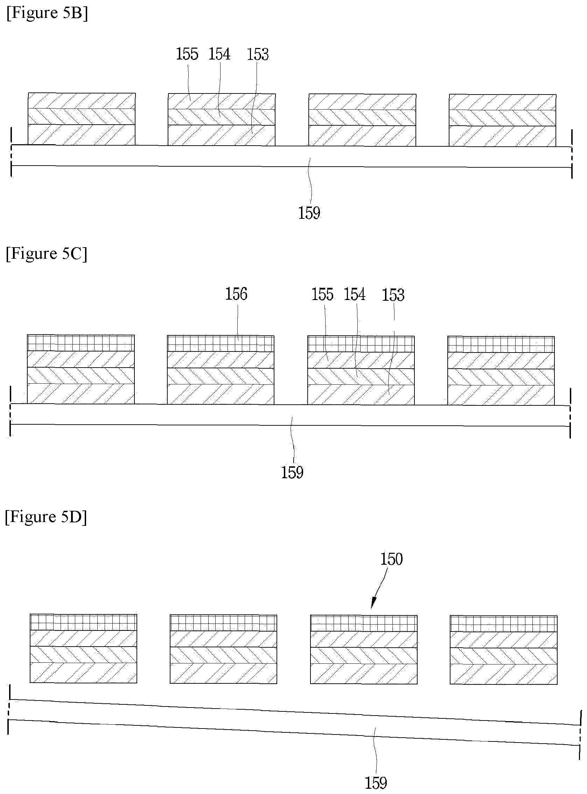

Next, at least some of the first conductivity type semiconductor layer 153, the active layer 154, and the second conductivity type semiconductor layer 155 are removed to form a plurality of semiconductor light emitting devices (refer to FIG. 5B).

More specifically, isolation is performed so that a plurality of light emitting devices form a light emitting device array. That is, the first conductivity type semiconductor layer 153, the active layer 154, and the second conductivity type semiconductor layer 155 are vertically etched to form a plurality of semiconductor light emitting devices.

If a horizontal semiconductor light emitting device is formed, the active layer 154 and the second conductivity type semiconductor layer 155 are partially removed in the vertical direction, a mesa process in which the first conductivity type semiconductor layer 153 is exposed to the outside, and an isolation process in which the first conductivity type semiconductor layer is etched to form a plurality of semiconductor light emitting device arrays can be performed thereafter.

Next, second conductive electrodes 156 (or p-type electrodes) are respectively formed on one surface of the second conductivity type semiconductor layer 155 (refer to FIG. 5C). The second conductive electrode 156 can be formed by a deposition method such as sputtering, but the present invention is not limited thereto. However, when the first conductivity type semiconductor layer and the second conductivity type semiconductor layer are an n-type semiconductor layer and a p-type semiconductor layer, respectively, the second conductive electrode 156 can be an n-type electrode.

Next, the growth substrate 159 is removed to provide a plurality of semiconductor light emitting devices. For example, the growth substrate 1059 can be removed using a laser lift-off (LLO) method or a chemical lift-off (CLO) method (refer to FIG. 5D).

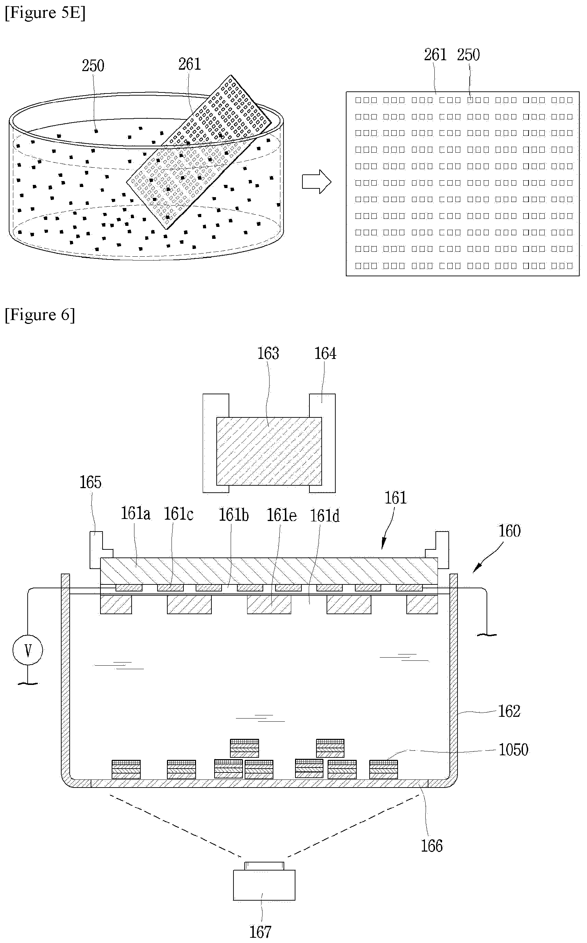

Thereafter, a step of settling the semiconductor light emitting devices 150 on a substrate in a chamber filled with a fluid is performed (refer to FIG. 5E).

For example, the semiconductor light emitting devices 150 and the substrate are put in a chamber filled with a fluid, and the semiconductor light emitting devices are self-assembled on the substrate 1061 using flow, gravity, surface tension, and the like. In this case, the substrate can be the assembly substrate 161.

As another example, it is also possible to put a wiring substrate in a fluid chamber instead of the assembly substrate 161 so that the semiconductor light emitting devices 150 are directly disposed on the wiring substrate. In this case, the substrate can be a wiring substrate. However, for convenience of description, in the present invention, the substrate is provided as the assembly substrate 161 to exemplify that the semiconductor light emitting devices 1050 are mounted.

Cells (not shown) in which the semiconductor light emitting devices 150 are inserted can be provided in the assembly substrate 161 to facilitate mounting of the semiconductor light emitting devices 150 on the assembly substrate 161. Specifically, cells in which the semiconductor light emitting devices 150 are disposed are formed on the assembly substrate 161 at positions where the semiconductor light emitting devices 150 are aligned with the wiring electrodes. The semiconductor light emitting devices 150 are assembled to the cells while moving in the fluid.

After arranging a plurality of semiconductor light emitting devices on the assembly substrate 161, if the semiconductor light emitting devices of the assembly substrate 161 are transferred to a wiring substrate, large-area transfer is possible. Accordingly, the assembly substrate 161 can be referred to as a temporary substrate.

On the other hand, in order to apply the self-assembly method described above to the manufacture of a large-screen display, it is necessary to increase the transfer yield. The present invention proposes a method and device for minimizing the influence of gravity or frictional force and preventing non-specific binding in order to increase the transfer yield.

In this case, in the display device according to the present invention, a magnetic material is disposed on a semiconductor light emitting device to move the semiconductor light emitting device using magnetic force, and the semiconductor light emitting device is disposed at a pre-set position by using an electric field during the movement process. Hereinafter, such a transfer method and device will be described in more detail with the attached drawings.

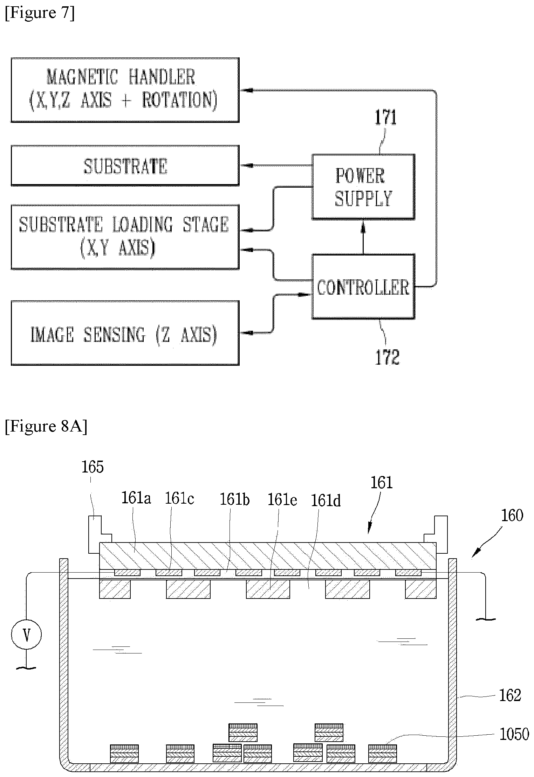

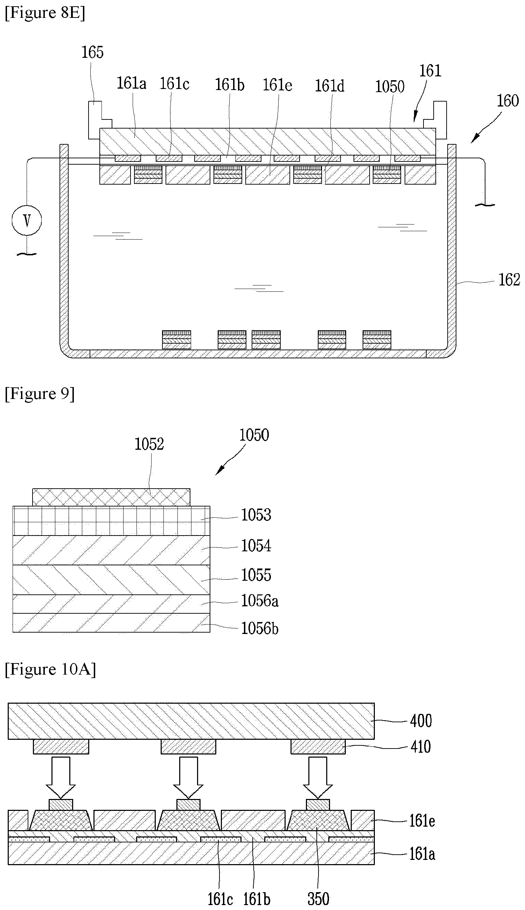

FIG. 6 is a conceptual diagram illustrating an example of a self-assembly device for a semiconductor light emitting device according to the present invention, and FIG. 7 is a block diagram of the self-assembly device of FIG. 6. FIGS. 8A to 8D are conceptual views illustrating a process of self-assembly a semiconductor light emitting device using the self-assembly device of FIG. 6, and FIG. 9 is a conceptual diagram for explaining the semiconductor light emitting device of FIGS. 8A to 8D.

Referring to FIGS. 6 and 7, the self-assembly device 160 of the present invention can include a fluid chamber 162, a magnet 163, and a position control unit 164.

The fluid chamber 162 has a space for accommodating a plurality of semiconductor light emitting devices. The space can be filled with a fluid, and the fluid can include water as an assembly solution. Accordingly, the fluid chamber 162 can be a water tank and can be configured as an open type. However, the present invention is not limited thereto, and the fluid chamber 162 can be of a closed type in which the space is a closed space.

In the fluid chamber 162, the substrate 161 can be disposed such that an assembly surface on which the semiconductor light emitting devices 150 are assembled faces downward. For example, the substrate 161 can be transferred to an assembly position by a transfer unit, and the transfer unit can include a stage 165 on which the substrate is mounted. The position of the stage 165 is adjusted by the controller, and through this, the substrate 161 can be transferred to the assembly position.

At this time, the assembly surface of the substrate 161 faces the bottom of the fluid chamber 150 in the assembly position. As shown, the assembly surface of the substrate 161 is arranged to be immersed in the fluid in the fluid chamber 162. Accordingly, the semiconductor light emitting device 150 moves to the assembly surface in the fluid.

The substrate 161 is an assembly substrate capable of forming the electric field, and can include a base part 161a, a dielectric layer 161b, and a plurality of electrodes 161c.

The base part 161a can be made of an insulating material, and the plurality of electrodes 161c can be thin film or thick film bi-planar electrodes patterned on one surface of the base part 161a. The electrode 161c can be formed of, for example, a stack of Ti/Cu/Ti, Ag paste, ITO, or the like.

The dielectric layer 161b can be made of an inorganic material such as SiO2, SiNx, SiON, Al2O3, TiO2, HfO2, or the like. Alternatively, the dielectric layer 161b can be formed of a single layer or a multi-layer as an organic insulator. The thickness of the dielectric layer 161b can be in the range of several tens of nm to several µm.

Furthermore, the substrate 161 according to the present invention includes a plurality of cells 161d partitioned by barrier wall. The cells 161d are sequentially arranged in one direction and can be made of a polymer material. Also, the barrier wall 161e forming the cells 161d are shared with the neighboring cells 161d. The barrier wall 161e protrudes from the base part 161a, and the cells 161d can be sequentially disposed along one direction by the barrier wall 161e. More specifically, the cells 161d can be sequentially arranged in the column and row directions, respectively, and can have a matrix structure.

Inside the cells 161d, as shown, a groove for accommodating the semiconductor light emitting device 150 is provided, and the groove can be a space defined by the barrier wall 161e. The shape of the groove can be the same as or similar to that of the semiconductor light emitting device. For example, when the semiconductor light emitting device has a rectangular shape, the groove can have a rectangular shape. Also, although not shown, when the semiconductor light emitting device has a circular shape, the grooves formed in the cells can have a circular shape. Furthermore, each of the cells is configured to accommodate a single semiconductor light emitting device. That is, one semiconductor light emitting device is accommodated in one cell.

Meanwhile, the plurality of electrodes 161c can include a plurality of electrode lines disposed at the bottom of each of the cells 161d, and the plurality of electrode lines can extend to adjacent cells.

The plurality of electrodes 161c are disposed below the cells 161d, and different polarities are applied to each other to generate an electric field in the cells 161d. To form the electric field, the dielectric layer can form the bottom of the cells 161d while covering the plurality of electrodes 161c with the dielectric layer. In this structure, when different polarities are applied to the pair of electrodes 161c under each of the cells 161d, an electric field can be formed, and the semiconductor light emitting device can be inserted into the cells 161d by the electric field.

In the assembly position, the electrodes of the substrate 161 are electrically connected to the power supply unit 171. The power supply unit 171 applies power to the plurality of electrodes to generate the electric field.

As shown, the self-assembly device can include a magnet 163 for applying a magnetic force to the semiconductor light emitting devices. The magnet 163 is spaced apart from the fluid chamber 162 to apply a magnetic force to the semiconductor light emitting devices 150. The magnet 163 can be disposed to face the opposite surface of the assembly surface of the substrate 161, and the position of the magnet is controlled by the position controller 164 connected to the magnet 163.

The semiconductor light emitting device 1050 can include a magnetic material to move in the fluid by the magnetic field of the magnet 163.

Referring to FIG. 9, in a semiconductor light emitting device including a magnetic material can include a first conductive electrode 1052 and a second conductive electrode 1056, a first conductivity type semiconductor layer 1053 on which the first conductive electrode 1052 is disposed, a second conductivity type semiconductor layer 1055 overlapping the first conductivity type semiconductor layer 1052 and on which the second conductive electrode 1056 is disposed, and an active layer 1054 disposed between the first and second conductivity type semiconductor layers 1053 and 1055.

Here, the first conductivity type can be a p-type, and the second conductivity type can be configured as an n-type, and vice versa. Also, as described above, it can be a semiconductor light emitting device without the active layer.

Meanwhile, in the present invention, the first conductive electrode 1052 can be generated after the semiconductor light emitting device is assembled on the wiring substrate by self-assembly of the semiconductor light emitting device. Also, in the present invention, the second conductive electrode 1056 can include the magnetic material. The magnetic material can mean a magnetic metal. The magnetic material can be Ni, SmCo, or the like, and as another example, can include a material corresponding to at least one of Gd-based, La-based, or Mn-based materials.

The magnetic material can be provided on the second conductive electrode 1056 in the form of particles. Alternatively, in a conductive electrode including a magnetic material, one layer of the conductive electrode can be formed of a magnetic material. For this example, as shown in FIG. 9, the second conductive electrode 1056 of the semiconductor light emitting device 1050 can include a first layer 1056a and a second layer 1056b. Here, the first layer 1056a can include a magnetic material, and the second layer 1056b can include a metal material rather than a magnetic material.

As shown, in this example, the first layer 1056a including a magnetic material can be disposed to contact the second conductivity type semiconductor layer 1055. In this case, the first layer 1056a is disposed between the second layer 1056b and the second conductivity type semiconductor layer 1055. The second layer 1056b can be a contact metal connected to the second electrode of the wiring substrate. However, the present invention is not necessarily limited thereto, and the magnetic material can be disposed on one surface of the first conductivity type semiconductor layer.

Referring back to FIGS. 6 and 7, more specifically, the self-assembly device can include a magnet handler capable of automatically or manually moving the x, y, and z axes on the upper side of the fluid chamber, or a motor capable of rotating the magnet 163. The magnet handler and the motor can constitute the position control unit 164. Through this, the magnet 163 rotates in a horizontal direction, clockwise or counterclockwise direction with the substrate 161.

Meanwhile, a light-transmitting bottom plate 166 can be formed in the fluid chamber 162, and the semiconductor light emitting devices can be disposed between the bottom plate 166 and the substrate 161. An image sensor 167 can be disposed to face the bottom plate 166 to monitor the inside of the fluid chamber 162 through the bottom plate 166. The image sensor 167 is controlled by the controller 172 and can include an inverted type lens and a CCD to observe the assembly surface of the substrate 161.

The self-assembly device described above can be made to use a combination of a magnetic field and an electric field. Using this, the semiconductor light emitting devices can be mounted at a pre-set position on the substrate by the electric field while the semiconductor light emitting devices are moved by a change in the position of the magnet. Hereinafter, the assembly process using the self-assembly device described above will be described in more detail.

First, a plurality of semiconductor light emitting devices 1050 including a magnetic material are formed through the process described with reference to FIGS. 5A to 5C. In this case, in the process of forming the second conductive electrode of FIG. 5C, a magnetic material can be deposited on the semiconductor light emitting device.

Next, the substrate 161 is transferred to the assembly position, and the semiconductor light emitting devices 1050 are put into the fluid chamber 162 (refer to FIG. 8A).

As described above, the assembly position of the substrate 161 can be a position in which the assembly surface of the substrate 161 on which the semiconductor light emitting devices 1050 are assembled faces downward in the fluid chamber 162.

In this case, some of the semiconductor light emitting devices 1050 can sink to the bottom of the fluid chamber 162 and some can float in the fluid. When the light-transmitting bottom plate 166 is provided in the fluid chamber 162, some of the semiconductor light emitting devices 1050 can sink to the bottom plate 166.

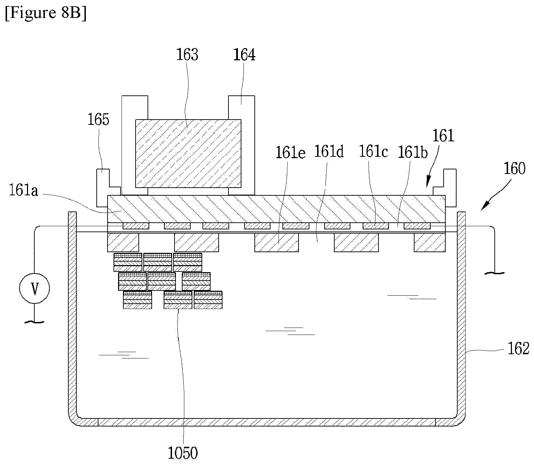

Next, a magnetic force is applied to the semiconductor light emitting devices 1050 so that the semiconductor light emitting devices 1050 vertically float in the fluid chamber 162 (refer to FIG. 8B).

When the magnet 163 of the self-assembly device moves from its original position to the opposite surface of the assembly surface of the substrate 161, the semiconductor light emitting devices 1050 are raised in the fluid toward the substrate 161. The original position can be a position deviated from the fluid chamber 162. As another example, the magnet 163 can be configured as an electromagnet. In this case, electricity is supplied to the electromagnet to generate an initial magnetic force.

Meanwhile, in this example, if the magnitude of the magnetic force is adjusted, the separation distance between the assembly surface of the substrate 161 and the semiconductor light emitting devices 1050 can be controlled. For example, the separation distance is controlled using the weight, buoyancy, and magnetic force of the semiconductor light emitting devices 1050. The separation distance can be several millimeters to several tens of micrometers from the outermost surface of the substrate.

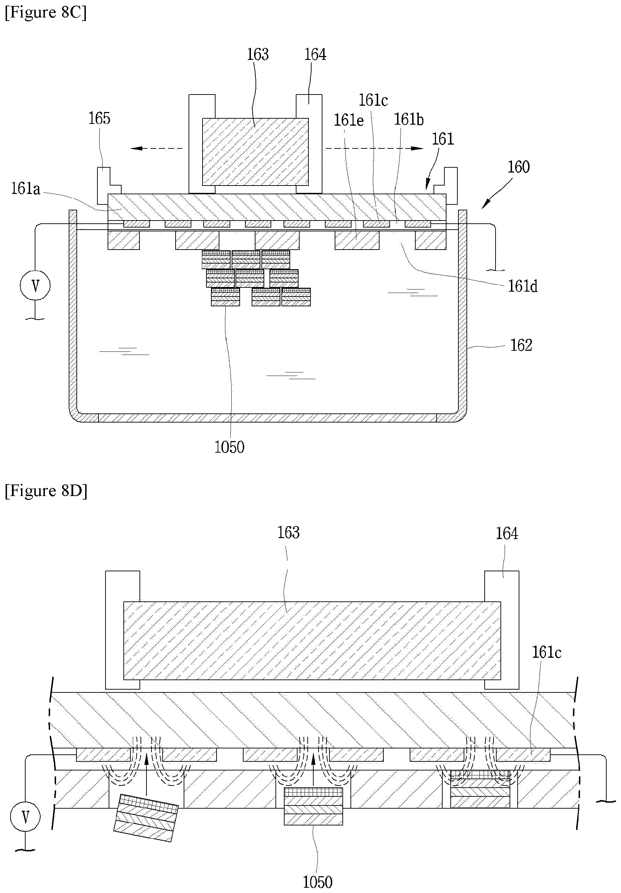

Next, a magnetic force is applied to the semiconductor light emitting devices 1050 so that the semiconductor light emitting devices 1050 move in one direction in the fluid chamber 162. For example, the magnet 163 moves in a direction parallel to the substrate, clockwise or counterclockwise (refer to FIG. 8C). In this case, the semiconductor light emitting devices 1050 move in a direction parallel to the substrate 161 at a position spaced apart from the substrate 161 by the magnetic force.

Next, in the process of moving the semiconductor light emitting devices 1050, a step of inducing the semiconductor light emitting devices 1050 to the pre-set position by applying an electric field so as to be disposed at a pre-set position of the substrate 161 is performed (refer to FIG. 8C). For example, while the semiconductor light emitting devices 1050 are moving in a direction horizontal to the substrate 161, and move in a direction perpendicular to the substrate 161 by the electric field and are disposed at a pre-set position on the substrate 161.

More specifically, power is supplied to the bi-planar electrode of the substrate 161 to generate an electric field, and by using this, assembly is induced only at a pre-set position. That is, by using the selectively generated electric field, the semiconductor light emitting devices 1050 are self-assembled at the assembly position of the substrate 161. To this end, cells in which the semiconductor light emitting devices 1050 are inserted can be provided on the substrate 161.

Thereafter, the unloading process of the substrate 161 proceeds, and the assembly process is completed. When the substrate 161 is an assembly substrate, a post-process for realizing a display device by transferring the semiconductor light emitting devices arranged as described above to a wiring substrate can be performed.

Meanwhile, after guiding the semiconductor light emitting devices 1050 to the pre-set position, the magnet 163 can be moved in a direction away from the substrate 161 so that the semiconductor light emitting devices 1050 remaining in the fluid chamber 162 fall to the bottom of the fluid chamber (FIG. 8D). As another example, when power supply is stopped when the magnet 163 is an electromagnet, the semiconductor light emitting devices 1050 remaining in the fluid chamber 162 fall to the bottom of the fluid chamber 162.

Thereafter, when the semiconductor light emitting devices 1050 at the bottom of the fluid chamber 162 are recovered, the recovered semiconductor light emitting devices 1050 can be reused.

Above In order to increase assembly yield in fluidic assembly, the self-assembly device and method described uses a magnetic field to focus distant components near a pre-set assembly site, and applies a separate electric field to the assembly site to selectively assemble components only at the assembly site. At this time, the assembly substrate is placed on the upper part of the water tank and the assembly surface is directed downward to minimize the effect of gravity due to the weight of the parts and prevent non-specific binding to eliminate defects. That is, to increase the transfer yield, the assembly substrate is placed on the upper part to minimize the influence of gravity or frictional force, and non-specific binding is prevented.

As described above, according to the present invention having the above configuration, in a display device in which individual pixels are formed of semiconductor light emitting devices, a large number of semiconductor light emitting devices can be assembled at once.

As described above, according to the present invention, it is possible to pixelate a large amount of semiconductor light emitting devices on a small-sized wafer and then transfer them to a large-area substrate. Through this, it is possible to manufacture a large-area display device at a low cost.

Meanwhile, the present invention provides a structure and method of an assembling substrate for increasing the yield of the above-described self-assembly process and the process yield after self-assembly. The present invention is limited to when the substrate 161 is used as an assembly substrate. That is, the assembly substrate, which will be described later, is not used as a wiring substrate of the display device. Accordingly, the substrate 161 will be referred to as an assembly substrate 161 hereinafter.

The present invention improves the process yield from two viewpoints. First, according to the present invention, an electric field is strongly formed at an unwanted position, and thus the semiconductor light emitting device is prevented from being seated at an unwanted position. Second, the present invention prevents the semiconductor light emitting devices from remaining on the assembly substrate when the semiconductor light emitting devices settled on the assembly substrate are transferred to another substrate.

The above-described problems are not individually achieved by different components. The two solutions described above can be achieved by organically combining the components to be described later and the assembly substrate 161 described above.

Before describing the present invention in detail, a post-process for manufacturing a display device after self-assembly will be described.

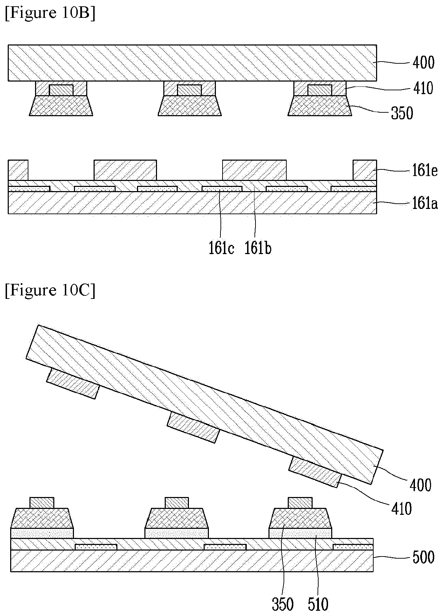

FIGS. 10A to 10C are conceptual views illustrating a state in which a semiconductor light emitting device is transferred after a self-assembly process according to the present invention.

When the self-assembly process described with reference to FIGS. 8A to 8E is completed, the semiconductor light emitting devices are seated at a preset position of the assembly substrate 161. The semiconductor light emitting devices settled on the assembly substrate 161 are transferred to another substrate at least once. In the present specification, an embodiment in which the semiconductor light emitting devices settled on the assembly substrate 161 are transferred twice, but not limited thereto, the semiconductor light emitting devices seated on the assembly substrate 161 can be transferred to another substrate once or three times or more.

On the other hand, immediately after the self-assembly process is completed, the assembly surface of the assembly substrate 161 is facing downward (or in the direction of gravity). For the self-assembly process, the assembly substrate 161 may be turned 180 degrees in a state in which the semiconductor light emitting device is seated. In this process, since there is a risk that the semiconductor light emitting device is separated from the assembly substrate 161, a voltage should be applied to the plurality of electrodes 161c (hereinafter, assembly electrodes) while the assembly substrate 161 is turned over. The electric field formed between the assembly electrodes prevents the semiconductor light emitting device from being separated from the assembly substrate 161 while the assembly substrate 161 is turned over.

If the assembly substrate 161 is turned over 180 degrees after the self-assembly process, the shape is as shown in FIG. 10A. Specifically, as shown in FIG. 10A, the assembly surface of the assembly substrate 161 is in a state facing upward (or in a direction opposite to gravity). In this state, the transfer substrate 400 is aligned above the assembly substrate 161.

The transfer substrate 400 is a substrate for transferring the semiconductor light emitting devices seated on the assembly substrate 161 to the wiring substrate by separating. The transfer substrate 400 can be formed of a polydimethylsiloxane (PDMS) material. Accordingly, the transfer substrate 400 can be referred to as a PDMS substrate.

The transfer substrate 400 is pressed to the assembly substrate 161 after being aligned with the assembly substrate 161. Thereafter, When the transfer substrate 400 is transferred to the upper side of the assembly substrate 161,

To this end, the surface energy between the semiconductor light emitting device 350 and the transfer substrate 400 should be higher than the surface energy between the semiconductor light emitting device 350 and the dielectric layer 161b. As the difference between the surface energy between the semiconductor light emitting device 350 and the transfer substrate 400 and the surface energy between the semiconductor light emitting device 350 and the dielectric layer 161b increases, since the probability that the semiconductor light emitting device 350 is separated from the assembly substrate 161 is increased, the greater the difference between the two surface energies, the more preferable.

On the other hand, when pressing the transfer substrate 400 to the assembly substrate 161, the transfer substrate 400 can include a plurality of protrusions 410 so that the pressure applied by the transfer substrate 400 is concentrated on the semiconductor light emitting device 350. The protrusions 410 can be formed at the same distance as the semiconductor light emitting devices seated on the assembly substrate 161. After aligning the protrusions 410 to overlap the semiconductor light emitting devices 350 and pressing the transfer substrate 400 to the assembly substrate 161, the pressure applied by the transfer substrate 400 can be concentrated only on the semiconductor light emitting devices 350. Through this, the present invention increases the probability that the semiconductor light emitting device is separated from the assembly substrate 161.

On the other hand, it is preferable that a portion of the semiconductor light emitting device is exposed to the outside of the groove in a state in which the semiconductor light emitting device is seated on the assembly substrate 161. When the semiconductor light emitting devices 350 are not exposed to the outside of the groove, the pressure of the transfer substrate 400 is not concentrated on the semiconductor light emitting devices 350 so that a probability that the semiconductor light emitting device 350 is separated from the assembly substrate 161 can be reduced.

Finally, referring to FIG. 10C, a step of transferring the semiconductor light emitting devices 350 from the transfer substrate 400 to the wiring substrate 500 is performed by pressing the transfer substrate 400 to the wiring substrate 500. In this case, a protrusion 510 can be formed on the wiring substrate 500. The transfer substrate 400 and the wiring substrate 500 are aligned so that the semiconductor light emitting devices 350 disposed on the transfer substrate 400 and the protrusion 510 overlap. Thereafter, when the transfer substrate 400 and the wiring substrate 500 are compressed, the probability that the semiconductor light emitting devices 350 are separated from the transfer substrate 400 can increase due to the protrusion 510.

Meanwhile, in order for the semiconductor light emitting devices 350 disposed on the transfer substrate 400 to be transferred to the wiring substrate 500, the surface energy between the semiconductor light emitting device 350 and the wiring substrate 500 should be higher than the surface energy between the semiconductor light emitting device 350 and the transfer substrate 400. As the difference between the surface energy between the semiconductor light emitting device 350 and the wiring substrate 500 and the surface energy between the semiconductor light emitting device 350 and the transfer substrate 400 increases, the probability that the semiconductor light emitting device 350 is separated from the transfer substrate 400 increases, it is preferable that the difference between the two surface energies is greater.

After transferring all the semiconductor light emitting devices 350 disposed on the transfer substrate 400 to the wiring substrate 500, a step of forming an electrical connection between the semiconductor light emitting devices 350 and a wiring electrode formed on a wiring substrate can be performed. The structure of the wiring electrode and the method of forming the electrical connection can vary depending on the type of the semiconductor light emitting device 350.

Meanwhile, although not shown, an anisotropic conductive film can be disposed on the wiring substrate 500. In this case, an electrical connection can be formed between the semiconductor light emitting devices 350 and the wiring electrodes formed on the wiring substrate 500 only by pressing the transfer substrate 400 and the wiring substrate 500.

Meanwhile, when manufacturing a display device including semiconductor light emitting devices emitting different colors, the method described with reference to FIGS. 10A to 10C can be implemented in various ways. Hereinafter, a method of manufacturing a display device including a semiconductor light emitting device that emits red (R), green (G), and blue (B) light will be described.

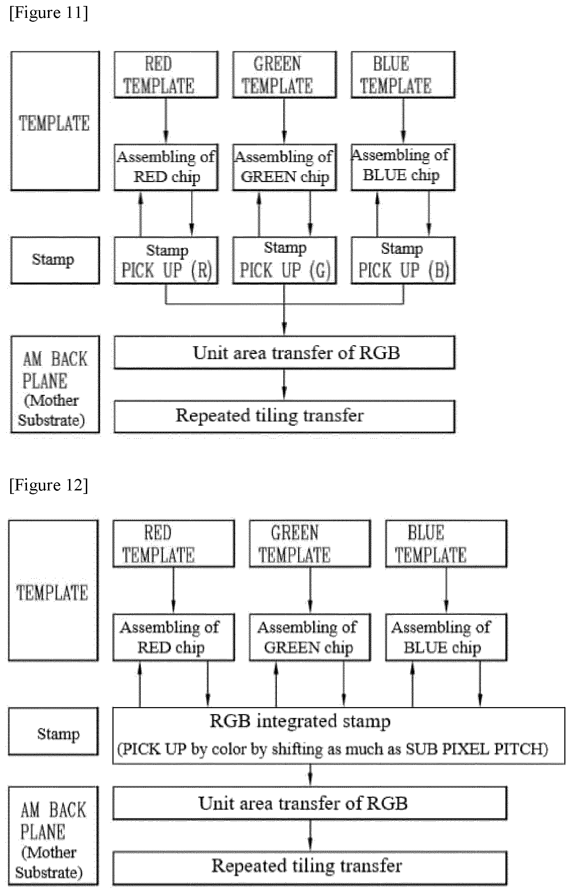

FIGS. 11 to 13 are flowcharts illustrating a method of manufacturing a display device including a semiconductor light emitting device that emits red (R), green (G), and blue (B) light.

The semiconductor light emitting devices emitting different colors can be individually assembled on different assembly substrates. Specifically, the assembly substrate 161 includes a first assembly substrate on which semiconductor light emitting devices emitting a first color are mounted, a second assembly substrate on which the semiconductor light emitting devices emitting a second color different from the first color are settled, a third assembly substrate on which semiconductor light emitting devices emitting a third color different from the first and second colors are settled. Different types of semiconductor light emitting devices are assembled on each assembly substrate according to the method described with reference to FIGS. 8A to 8E. For example, each of the semiconductor light emitting devices emitting red (R), green (G), and blue (B) light can be assembled on each of the first to third assembly substrates.

Referring to FIG. 11, a RED chip, a GREEN chip, and a BLUE chip can be assembled on each of the first to third assembly substrates RED TEMPLATE, GREEN TEMPLATE, and BLUE TEMPLATE. In this state, each of the RED chip, the green chip, and the BLUE chip can be transferred to the wiring substrate by different transfer substrates.

Specifically, the step of transferring the semiconductor light emitting devices seated on the assembly substrate to the wiring substrate can include a step of transferring the semiconductor light emitting devices (RED chips) emitting the first color from the first assembly substrate (RED TEMPLATE) to the first transfer substrate (stamp (R)) by pressing the first transfer substrate (stamp (R)) to the first assembly substrate (RED TEMPLATE), a step of transferring the semiconductor light emitting devices (GREEN chips) emitting the second color from the second assembly substrate (GREEN TEMPLATE) to the second transfer substrate (stamp (G)) by pressing the second transfer substrate (stamp (G)) to the second assembly substrate (GREEN TEMPLATE), a step of transferring the semiconductor light emitting devices (BLUE chips) emitting the third color from the third assembly substrate (BLUE TEMPLATE) to the third transfer substrate (stamp (B)) by pressing the third transfer substrate (stamp (B)) to the third assembly substrate (BLUE TEMPLATE).

Thereafter, a step of transferring the semiconductor light emitting devices emitting light of the first to third colors from each of the first to third transfer substrates to the wiring substrate by pressing each of the first to third transfer substrates to the wiring substrate proceeds.

According to the manufacturing method of FIG. 11, three types of assembly substrates and three types of transfer substrates are required to manufacture a display device including a RED chip, a GREEN chip, and a BLUE chip.

Alternatively, referring to FIG. 12, each of the RED chip, the GREEN chip, and the BLUE chip can be assembled on each of the first to third assembly substrates RED TEMPLATE, GREEN TEMPLATE, and BLUE TEMPLATE. In this state, each of the RED chip, the GREEN chip, and the BLUE chip can be transferred to the wiring substrate by the same transfer substrate.

Specifically, the step of transferring the semiconductor light emitting devices seated on the assembly substrate to a wiring substrate includes a step of transferring the semiconductor light emitting devices (RED chips) emitting the first color from the first assembly substrate (RED TEMPLATE) to the transfer substrate (RGB integrated stamp) by pressing the transfer substrate (RGB integrated stamp) to the first assembly substrate (RED TEMPLATE), a step of transferring the semiconductor light emitting devices (GREEN chips) emitting the second color from the second assembly substrate (GREEN TEMPLATE) to the transfer substrate (RGB integrated stamp) by pressing the transfer substrate (RGB integrated stamp) to the second assembly substrate (GREEN TEMPLATE), a step of transferring the semiconductor light emitting devices (BLUE chips) emitting the third color from the third assembly substrate (BLUE TEMPLATE) to the transfer substrate (RGB integrated stamp) by pressing the transfer substrate (RGB integrated stamp) to the third assembly substrate (BLUE TEMPLATE).

In this case, alignment positions between each of the first to third assembly substrates and the transfer substrate may be different from each other. For example, when alignment between the assembly substrate and the transfer substrate is completed, the relative position of the transfer substrate with respect to the first assembly substrate and the relative position of the transfer substrate with respect to the second assembly substrate may be different from each other. The transfer substrate may shift the alignment position by the PITCH of the SUB PIXEL whenever the type of the assembly substrate is changed. In this way, when the transfer substrate is sequentially pressed to the first to third assembly substrates, all three types of chips can be transferred to the transfer substrate.

Thereafter, as in FIG. 11, a step of transferring the semiconductor light emitting devices emitting light of the first to third colors from the transfer substrate to the wiring substrate is performed by pressing the transfer substrate to the wiring substrate.

According to the manufacturing method of FIG. 12, three types of assembly substrates and one type of transfer substrate are required to manufacture a display device including a RED chip, a GREEN chip, and a BLUE chip.

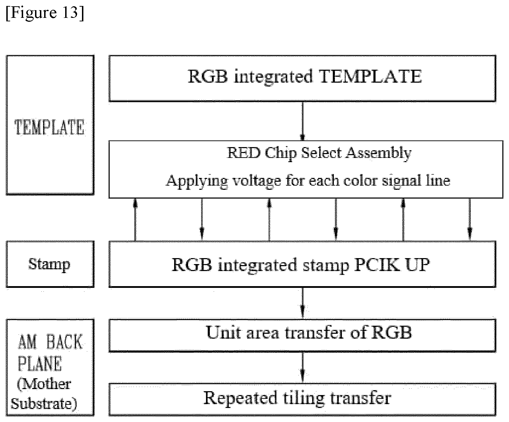

Unlike the above-described FIGS. 11 and 12, according to FIG. 13, each of the RED chip, the GREEN chip, and the BLUE chip can be assembled on one assembly substrate (RGB integrated TEMPLATE). In this state, each of the RED chip, the GREEN chip, and the BLUE chip can be transferred to the wiring substrate by the same transfer substrate (RGB integrated stamp).

According to the manufacturing method of FIG. 13, one type of assembly substrate and one type of transfer substrate are required to manufacture a display device including a RED chip, a GREEN chip, and a BLUE chip.

As described above, when manufacturing a display device including semiconductor light emitting devices emitting light of different colors, the manufacturing method can be implemented in various ways.

The present invention relates to a substrate for manufacturing a display device used for manufacturing a display device through the self-assembly method according to FIGS. 10A to 10C described above.

Hereinafter, embodiments of the present invention will be described with reference to the accompanying drawings.

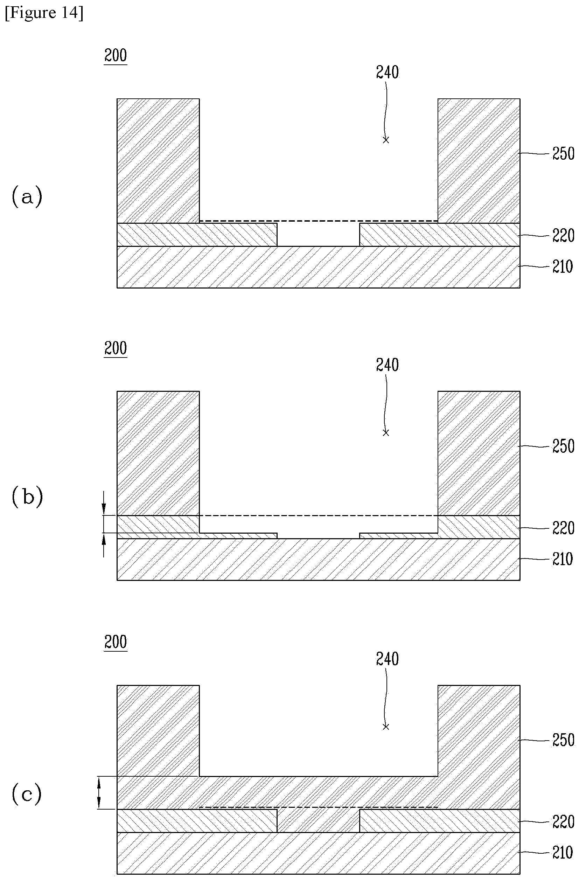

FIGS. 14A to 14C are conceptual views illustrating a cell internal cross-section of a substrate of related art for manufacturing a display device.

As shown in FIG. 14, the substrate of related art for manufacturing a display device 200 may have a structure in which the barrier wall part 250 are formed directly on the assembly electrodes 220 or a structure in which a dielectric layer 161b is formed on the assembly electrodes 161c as shown in FIGS. 8A to 8E.

In particular, in the structure shown in FIG. 14, when the cell 240 is formed, the barrier wall part 250 is etched to a predetermined depth or more, so that even some of the assembly electrodes 220 are etched (refer to FIG. 14(b)) or the etching is not performed to an appropriate depth (refer to FIG. 14(c)). Such non-uniform etching may occur more frequently in a large-area substrate.

Also, even in the case of the substrate 161 shown in FIGS. 8A to 8E, it is impossible to selectively etch only the barrier wall 161e formed on the dielectric layer 161c, so the problem of the structure of FIG. 14 could not be completely solved.

The substrate 300 (or substrate) for manufacturing a display device according to the present invention may be for solving the problems of the substrate of related art for manufacturing a display device shown in FIG. 14.

The substrate 300 for manufacturing a display device according to the present invention includes a base part 310 and assembly electrodes 320 formed on the base part 310, an etch stop layer 330 and a barrier wall part 350 forming the cell 340.

The substrate 300 for manufacturing a display device according to the present invention may be a substrate on which semiconductor light emitting devices are temporarily mounted by a self-assembly method using an electric field and a magnetic field.

The base part 310 may be a rigid substrate made of glass, quartz, or the like, or a flexible substrate including a polymer material. For example, the flexible substrate can include flexible and insulating PI, PEN, PET, and the like.

The assembly electrodes 320 extending in one direction can be disposed on the base part 310 at predetermined intervals. The assembly electrodes 320 can be formed to a thickness of several hundred nm.

A voltage signal for forming an electric field can be applied to the assembly electrodes 320. Accordingly, the assembly electrodes 320 can be formed of a conductive metal corresponding to any one of Al, Mo, Cu, Ag, and Ti, or an alloy selected from these.

The substrate 300 for manufacturing a display device according to the present invention can include an etch stop layer 330 formed on at least a partial region of the base part 310. The etch stop layer 330 can be formed of a material having a high etch selectivity, and can prevent a portion of the assembly electrodes 320 from being etched due to excessive etching.

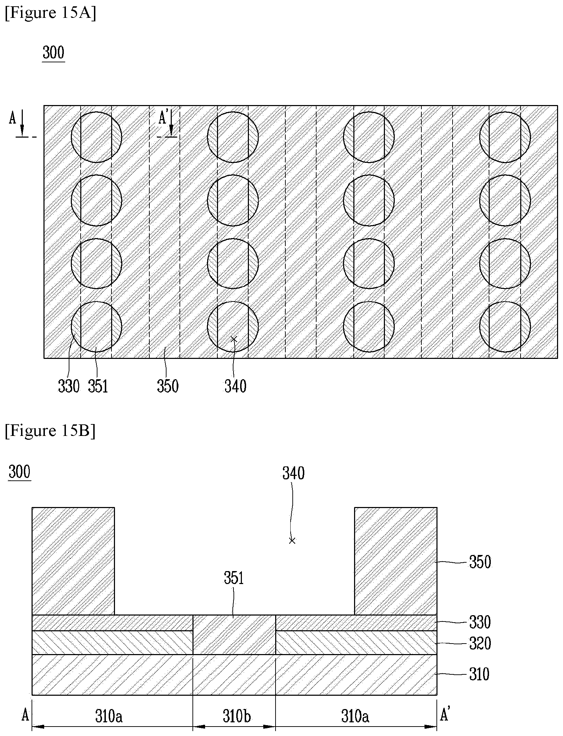

In an embodiment, the etch stop layer 330 can be formed on at least the first region 310a in which the assembly electrodes 320 are formed among the entire region of the base part 310 (FIGS. 15A to 15C). In another embodiment, the etch stop layer 330 can be formed on the first region 310a in which the assembly electrodes 320 are formed and the second region 310b in which the assembly electrodes 320 are not formed among the entire region of the base part 310. That is, the etch stop layer 330 can be formed on the entire surface of the base part 310 (also 16a and 16b).

The etch stop layer 330 may be an oxide layer containing at least one of In, Sn and Zn, for example, it may be Indium-Tin Oxide (ITO), Zinc Oxide (ZnO), Indium-Zinc Oxide (IZO), or the like. Also, the etch stop layer 330 can be formed to a thickness of several to several hundred nm.

The barrier wall part 350 can be formed on the etch stop layer 330. The barrier wall part 350 can be formed of an inorganic or organic insulating material.

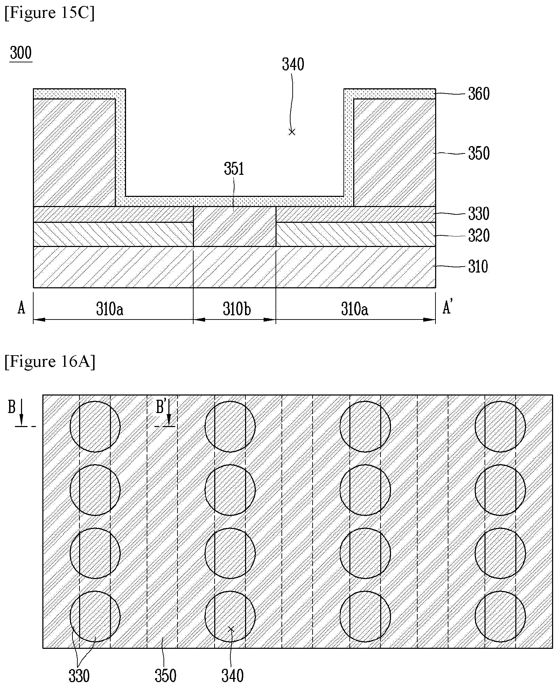

The barrier wall part 350 can be formed on the etch stop layer 330 while forming the cell 340 on which the semiconductor light emitting device is seated along the extending direction of the assembly electrodes 320 as shown in FIGS. 15A and 16A. Accordingly, the cells 340 can be arranged in a matrix arrangement on the base part 310.

Also, the cell 340 can be formed to overlap a portion of the assembly electrodes 320. Specifically, the cell 340 can be formed to overlap two adjacent assembly electrodes 320 constituting a pair of electrode pairs. An alternating voltage can be applied to the pair of electrode pairs.

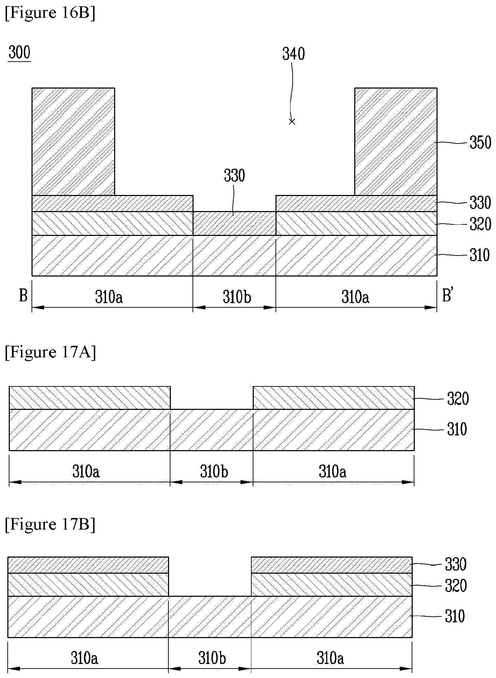

Next, an embodiment of the etch stop layer 330 according to the present invention will be described with reference to FIGS. 15 and 16.

FIG. 15A is a view showing a top surface of a substrate for manufacturing a display device according to a first embodiment of the present invention, and FIGS. 15B and 15C are cross-sectional views taken along line AA' of FIG. 15A. FIG. 16A is a view showing a top surface of a substrate for manufacturing a display device according to a second exemplary embodiment of the present invention, and FIG. 16B is a cross-sectional view taken along line BB' of FIG. 16A.

According to the embodiment of FIGS. 15A to 15C, the etch stop layer 330 can be formed on the first region 310a in which at least the assembly electrodes 320 are formed among the entire region of the base part 310 (first embodiment).

In the first embodiment, the etch stop layer 330 can be formed to have electrical conductivity, and can serve as the assembly electrodes 320. For example, the etch stop layer 330 can be formed to have a conductivity similar to that of the assembly electrodes 320, and can transmit a voltage signal for forming an electric field together with the assembly electrodes 320. In order to control the conductivity of the etch stop layer 330, the number of crystallinity or substitution atoms can be adjusted.

In the first embodiment, the first insulating layer 351 can be formed on the second region 310b in which the assembly electrodes 320 are not formed among the entire region of the base part 310. That is, the first insulating layer 351 can be formed between the assembly electrodes 320 and can insulate the adjacent assembly electrodes 320. The first insulating layer 351 can be a part of the barrier wall 350.

Also, in the first embodiment, the second insulating layer 360 formed along the inner surface of the cell 340 and one surface of the barrier wall part 350 can be included. The second insulating layer 360 can be formed to cover the etch stop layer 330 exposed on the inner surface of the cell 340. The second insulating layer 360 can be formed of an inorganic insulating material such as SiO2, SiNx, SiON, Al2O3, TiO2, HfO2, or the like.

According to the embodiment of FIGS. 16A and 16B, the etch stop layer 330 can be formed on the first region 310a in which the assembly electrodes 320 are formed and the second region 310b in which the assembly electrodes 320 are not formed among the entire region of the base part 310. That is, the etch stop layer 330 can be formed on the entire surface of the base part 310 (second embodiment).

In the second embodiment, the etch stop layer 330 can be formed of an insulating nonconductor. For example, the etch stop layer 330 may be a ZnO layer that is not heat treated or doped.

Also, in the second embodiment, since the etch stop layer 330 has insulating properties, even if the etch stop layer 330 is formed between the assembly electrodes 320, it is possible to prevent a short circuit between the adjacent assembly electrodes 320, therefore, an insulating layer covering the assembly electrodes 320 may not be separately formed.

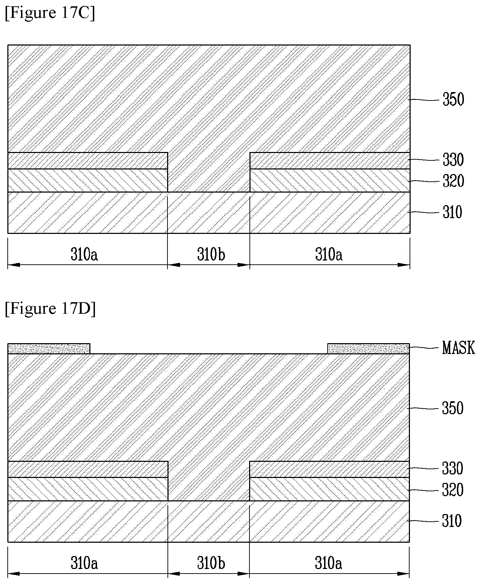

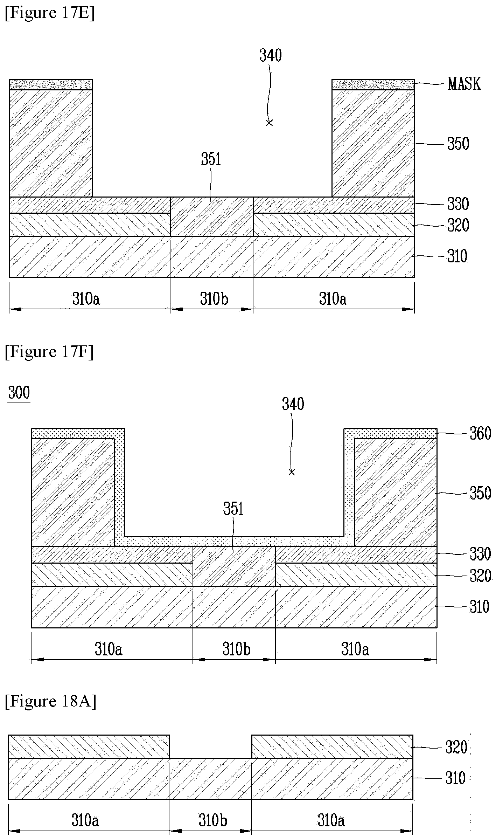

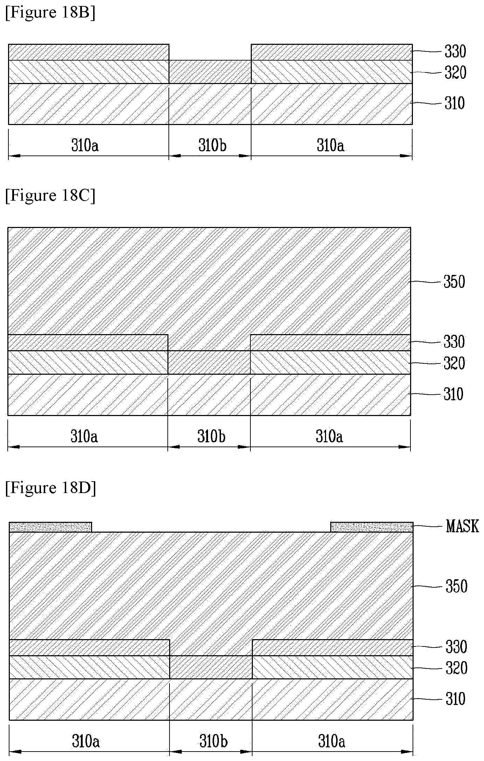

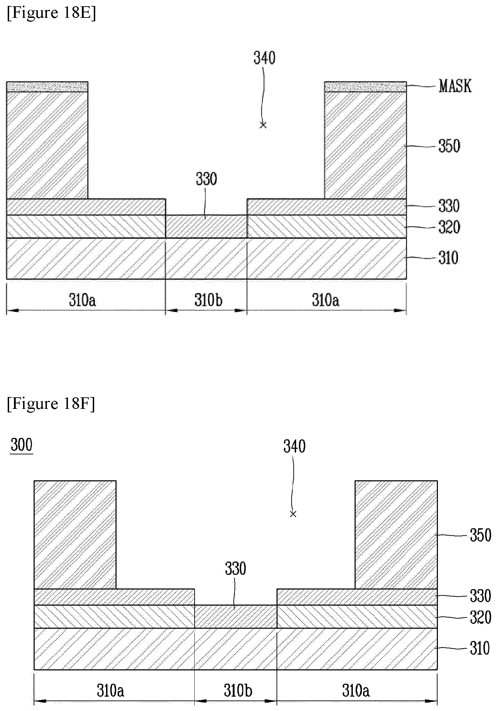

Next, a method of manufacturing the substrate 300 for manufacturing a display device according to the present invention will be described with reference to FIGS. 17 and 18.

FIGS. 17A to 17F are conceptual views for explaining a method of manufacturing a substrate for manufacturing a display device according to the first embodiment of the present invention, and FIGS. 18A to 18F are conceptual views illustrating a method of manufacturing a substrate for manufacturing a display device according to a second exemplary embodiment of the present invention.

### Method for manufacturing a substrate for manufacturing a display device (first embodiment)

First, the step of forming the assembly electrodes 320 extending in one direction on the base part 310 at predetermined intervals can be performed (refer to FIG. 17A).

The assembly electrodes 320 may be patterned after forming a mask on the base part 310, and may be performed by a PVD or CVD process. Through this step, the base part 310 can be divided into a first region 310a in which the assembly electrodes 320 are formed and a second region 310b in which the assembly electrodes 320 are not formed.

Next, a step of forming the etch stop layer 330 on the first region 310a in which the assembly electrodes 320 are formed among the entire region of the base part 310 can be performed (refer to FIG. 17B).

This step can be performed without removing the mask formed on the base part 310 in the step of forming the assembly electrodes 320, and can be performed by a PVD or CVD process. The etch stop layer 330 may be an oxide layer including at least one of In, Sn, and Zn.

After that, the step of forming the barrier wall part 350 on the first region 310a and the second region 310b of the base part 310 can be performed (FIG. 17C).

The barrier wall part 350 can be formed of an inorganic or organic insulating material.

Next, a step of forming the cell 340 on which the semiconductor light emitting device is seated can be performed by etching the barrier wall part 350 to a predetermined depth (refer to FIGS. 17D and 17E).

Specifically, the forming of the cell 340 can be performed by forming a mask pattern on the barrier wall part 350 and then etching a region where the mask pattern is not formed. The mask pattern can be formed to overlap the assembly electrodes 320 along the extending direction of the assembly electrodes 320.

Also, the barrier wall part 350 can be etched until the etch stop layer 330 is exposed, and the etching can be performed by a dry etching process. At this time, the etch stop layer 330 is not removed in the process of etching the barrier wall part 350 due to its high etch selectivity, so that the cells 340 can be uniformly formed (particularly, the depth of the cells 340).

In this step, a portion of the barrier wall part 350 formed on the second region 310b may not be removed, but can serve to insulate the adjacent assembly electrodes 320. The barrier wall part 350 remaining on the second region 310b corresponds to the above-described first insulating layer 351.

Meanwhile, the mask formed on the barrier wall part 350 may be removed after the cell 340 is formed.

In the case of the first embodiment, the step of additionally forming the second insulating layer 360 along the inner surface of the cell 340 and one surface of the barrier wall part 350 can be further performed (refer to FIG. 17F).

The second insulating layer 360 can be formed of an inorganic insulating material such as SiO2, SiNx, SiON, Al2O3, TiO2, HfO2, etc. For example, the second insulating layer 360 can be formed on the inner surface of the cell 340 and the barrier wall part 350 through a CVD process.

### Method for manufacturing a substrate for manufacturing a display device (the second embodiment)

First, a step of forming the assembly electrodes 320 extending in one direction on the base part 310 at predetermined intervals can be performed (refer to FIG. 18A).

The assembly electrodes 320 can be patterned after forming a mask on the base part 310, and may be formed by a PVD or CVD process. Through this step, the base part 310 may be divided into a first region 310a in which the assembly electrodes 320 are formed and a second region 310b in which the assembly electrodes 320 are not formed.

Next, a step of forming the etch stop layer 330 on the entire surface of the base part 310 may be performed (FIG. 18B).

In this step, since the etch stop layer 330 is formed in the first region 310a and the second region 310b of the base part 310, after removing the mask formed on the base part 310 in the step of forming the assembly electrodes 320, a PVD or CVD process can be performed. Also, the etch stop layer 330 can be an oxide layer including at least one of In, Sn, and Zn.

After that, the step of forming the barrier wall part 350 on the first region 310a and the second region 310b of the base part 310 may be performed (refer to FIG. 18C).

The barrier wall part 350 can be formed of an inorganic or organic insulating material.

Finally, a step of forming the cell 340 on which the semiconductor light emitting device is seated by etching the barrier wall part 350 by a predetermined depth can be performed (refer to FIGS. 18D to 18F).

Specifically, the step of the forming of the cell 340 can be performed by forming a mask pattern on the barrier wall part 350 and then etching a region where the mask pattern is not formed. The mask pattern can be formed to overlap the assembly electrodes 320 along the extending direction of the assembly electrodes 320.

Also, the barrier wall part 350 can be etched until the etch stop layer 330 is exposed, and the etching can be performed through a dry etching process. In this case, the etch stop layer 330 may not be removed in the process of etching the barrier wall part 350 because of the high etch selectivity. Accordingly, there is an effect of uniformly forming the cells 340 (in particular, the depth of the cells 340).

In this step, all of the barrier wall 350 formed on the second region 310b may be removed, and the mask formed on the barrier wall 350 may be removed after the cell 340 is formed.

The substrate for manufacturing a display device according to the present invention has an effect of forming an etch stop layer on at least the front surfaces of the assembly electrodes to uniformly form cells during the substrate manufacturing process. Specifically, since etching is performed until the etch stop layer formed on the assembly electrodes is exposed during cell formation, there is an effect that can prevent defects (defect due to over-etching) in which the assembly electrodes disposed under the etch stop layer are etched.

Also, the substrate for manufacturing a display device according to the present invention has an effect of improving the transfer speed and transfer yield of the semiconductor light emitting device through self-assembly.

The present invention described above is not limited to the configuration and method of the above-described embodiments, but the embodiments may be configured by selectively combining all or part of each embodiment so that various modifications can be made.

## Claims

1. A substrate for manufacturing a display device comprising:
a base part;
assembly electrodes extending in one direction and disposed on the base part at predetermined intervals;
an etch stop layer disposed on at least a portion of the base part; and
a barrier wall part disposed on the etch stop layer while forming a cell on which a semiconductor light emitting device is mounted along an extension direction of the assembly electrodes,
wherein the etch stop layer is disposed on at least a first area in which the assembly electrodes are disposed among an entire area of the base part.

2. The substrate according to claim 1, wherein the etch stop layer is further disposed on a second area in which the assembly electrodes are not disposed among the entire area of the base part.

3. The substrate according to claim 1, wherein the etch stop layer is an oxide layer comprising at least one of In, Sn, or Zn.

4. The substrate according to claim 1, further comprising a first insulation layer disposed on a second region in which the assembly electrodes are not formed among the entire region of the base part.

5. The substrate according to claim 4, further comprising a second insulating layer disposed along an inner surface of the cell and one surface of the barrier wall part.

6. A method of manufacturing a substrate for manufacturing a display device comprising:
a step of forming assembly electrode patterns extending in one direction on a base part at predetermined intervals;
a step of forming an etch stop layer on at least a first region in which the assembly electrodes are formed among an entire region of the base part;
a step of forming a barrier wall part on a second region in which the assembly electrodes are not formed among the entire region of the first region and the base part; and
a step of forming a cell in which a semiconductor light emitting device is seated by etching the barrier wall part to a predetermined depth.

7. The method according to claim 6, wherein the etch stop layer is further formed on the second region in which the assembly electrodes are not formed among the entire region of the base part.

8. The method according to claim 6, wherein the step of the forming of the cell comprises a step of etching the barrier wall part to expose the etch stop layer.

9. The method according to claim 6, wherein the etch stop layer is an oxide layer comprising at least one of In, Sn, or Zn.

10. The method according to claim 6, further comprising a step of forming a second insulating layer along an inner surface of the cell and one surface of the barrier wall part.
